(19) Europäisches Patentamt
European Patent Office
Office européen des brevets

(11) **EP 3 018 502 A2**

(12) **EUROPEAN PATENT APPLICATION**

(43) Date of publication:
**11.05.2016 Bulletin 2016/19**

(51) Int Cl.:
***G01V 99/00*** *(2009.01)*

(21) Application number: **15193199.5**

(22) Date of filing: **05.11.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.11.2014 US 201462076943 P**
**11.03.2015 US 201514644306**

(71) Applicants:
• **Services Petroliers Schlumberger**
**75007 Paris (FR)**
Designated Contracting States:
**FR**
• **Logined B.V.**
**2586 BJ S Gravenhage (NL)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventor: **PECHER, Radek**
**Abingdon, Oxfordshire OX14 1UJ (GB)**

(74) Representative: **Schlumberger Cambridge Research Limited**
**Intellectual Property Law**
**High Cross**
**Madingley Road**
**Cambridge CB3 0EL (GB)**

(54) **MODELING FLUID-CONDUCTING FRACTURES IN RESERVOIR SIMULATION GRIDS**

(57)     Systems, methods, and media for modeling fluid-conducting fractures in reservoir grid simulations. The method includes determining a model of an underground reservoir. The model includes one or more conductive fractures and a grid of three-dimensional (3D) reservoir cells. The method also includes determining the 3D reservoir cells that intersect the conductive fracture. The method further includes determining two-dimensional (2D) fracture cells representing the conductive fracture in the model. Additionally, the method includes determining fluid flow through the conductive fracture using fluid flow parameters of the plurality the 3D reservoir cells intersecting the fracture and fluid flow parameters of the 2D fracture cells. Further, the method includes updating the model based on the fluid flow.

FIG 5

## Description

### Cross-Reference to Related Applications

This application claims priority to U.S. Provisional Patent Application No. 62/076,943, which was filed on November 7, 2014 and is incorporated herein by reference in its entirety.

### Background

Operations, such as surveying, drilling, wireline testing, completions, production, planning and analysis can be performed to locate and gather valuable fluids (e.g., hydrocarbons) in underground geological formations (e.g., reservoirs). Surveys can be performed using acquisition methodologies, such as seismic scanners or surveyors to generate maps and other information of the formations. The maps and other information can be analyzed to determine whether the formations contain fluids and whether such fluids are reasonably recoverable.

Both natural and induced conductive fractures in underground geological formations accelerate the flow of fluids in reservoirs and, thus, improve primary recovery of the fluids. However, conductive fractures can also reduce efficiency during secondary recovery, for example, by shortening the water breakthrough times. Accordingly, to maximize recovery, analysts may use prediction scenarios to numerically model reservoir simulators and, thereby, assess the influence of the conductive fractures. There are several approaches to the modeling of conductive fractures in finite-difference (FD) or control-volume (CV) based reservoir grids. These approaches, however, have respective tradeoffs between the accuracy of the modeling and the corresponding computational costs.

### Summary

The present disclosure is directed to modeling fluid-conducting fractures in reservoir grid simulations. Method, systems, and computer program products in accordance with the present disclosure perform operations including determining a model of an underground reservoir, wherein the model includes a conductive fracture and a grid of three-dimensional (3D) reservoir cells. The operations also include determining the 3D reservoir cells that intersect the conductive fracture. The operations further include determining two-dimensional (2D) fracture cells representing the conductive fracture in the model. Additionally, the operations include determining fluid flow through the conductive fracture using fluid flow parameters of the plurality the 3D reservoir cells intersecting the fracture and fluid flow parameters of the 2D fracture cells. Further, the operations include updating the model based on the fluid flow.

It will be appreciated that this summary is intended merely to introduce some aspects of the present methods, systems, and media, which are more fully described and/or claimed below. Accordingly, this summary is not intended to be limiting.

### Brief Description of the Drawings

The accompanying drawings, which are incorporated in and constitute a part of this specification, illustrate embodiments of the present teachings and together with the description, serve to explain the principles of the present teachings.

Figure 1 illustrates a block diagram of an example of an environment for implementing methods and systems in accordance with aspects of the present disclosure;
Figure 2 illustrates an aerial view of an example of a geological formation including fractures;
Figure 3 illustrates a multi-segment network model for fluid-conducting fractures;
Figure 4 illustrates a model of intersections between a reservoir cell and a number of fracture cells modeled in accordance with aspects of the present disclosure;
Figure 5 illustrates a flow diagram of a process for modeling a fracture cell, reservoir cell intersection in accordance with aspects of the present disclosure; and
Figure 6 illustrates a block diagram of a computing system in accordance with aspects of the present disclosure.

### Detailed Description

The present disclosure is directed to modeling geologic formations and, more specifically, to modeling fluid-conducting fractures in reservoir grid simulations. Methods and systems in accordance with aspects of the present disclosure geometrically model fluid-conducting fractures of a fracture-rock fluid-flow model with high-accuracy in relation to computational costs of the modeling. Additionally, the modeling of fluid-conducting fractures by the methods and systems disclosed herein provides flexibility in simulation shapes and locations of the fractures without adapting the surrounding reservoir model. Further, the methods and systems disclosed herein provide a choice in the number of unknowns to solve for in the models.

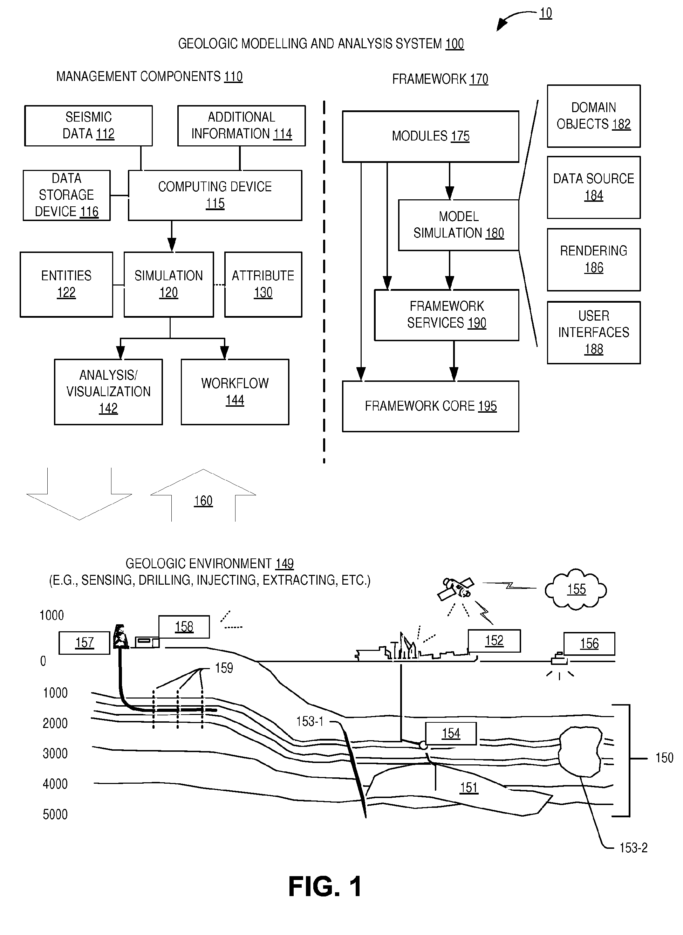

Figure 1 illustrates a block diagram of an environment 10 for implementing methods and systems disclosed herein in accordance with aspects of the present disclosure. The environment 10 includes a geologic modeling and analysis system 100 and a geologic environment 149. The management components 110 can allow for direct or indirect management of sensing, drilling, injecting, extracting, etc., with respect to the geologic environment 149. The geologic environment 149 can include, for example, a sedimentary basin 150, a reservoir 151, one or more faults 153-1, one or more geobodies 153-2, and the like. The geologic modeling and analysis system 100 can obtain information about the geologic environment 149 can be obtained as feedback 160, which can be input to one or more of the management components 110.

In accordance with aspects of the present disclosure, the geologic modeling and analysis system 100 includes hardware and software that perform the processes and functions described herein. In embodiments, the geologic modeling and analysis system 100 includes a computing device 115 and a hardware data storage device 116. In embodiments, the computing device 130 includes one or more processors, one or more memory devices (e.g., RAM and ROM), one or more I/O interfaces, and one or more network interfaces. The memory devices can include a local memory (e.g., a random access memory and a cache memory) employed during execution of program instructions. The data storage device 116 can comprise a computer-readable, non-volatile hardware storage device that stores information and program instructions. For example, the data storage device 116 can be one or more flash drives and/or hard disk drives.

Using the processor, the computing device 115 executes computer program instructions (e.g., an operating system and/or application programs), which can be stored in the memory devices and/or data storage device 116. Moreover, in accordance with aspects of the present disclosure, the computing device 115 can execute computer program instructions of the management component 110 and the framework 170.

In accordance with aspects of the present disclosure, the management components 110 include a seismic data component 112, an additional information component 114 (e.g., well/logging data), a computing device 115, a data storage device 116, a simulation component 120, an attribute component 130, an analysis/visualization component 142 and a workflow component 144. In operation, seismic data and information provided per the seismic data component 112 and the additional information component 114 may be input to the simulation component 120.

In accordance with aspects of the present disclosure, the simulation component 120 is software, hardware, or a combination thereof that, when executed by the computing device 115, causes that geologic modeling and analysis system 100 to model and/or simulate fluid-conducting fractures in the geologic environment 149. In embodiments, the simulation component 120 can use entities 122, which can include earth entities or geological objects such as wells, surfaces, bodies, reservoirs, etc. In the geologic modeling and analysis system 100, the entities 122 can include virtual representations of actual physical entities of, for example, the geologic environment 149 that are reconstructed for purposes of simulation by the simulation component 120. The entities 122 can be determined based on data acquired via sensing, observation, etc. (e.g., the seismic data 112 and other information 114), which can be obtained from the geologic environment 149 via feedback 160. Each of the entities 122 can be characterized by one or more properties. For example, a fracture entity can be characterized by one or more properties such as location, size, shape, volume, orientation, pressure, porosity, fluid density, pore volume, etc. The properties can represent one or more measurements (e.g., data acquired from the geologic environment and reference data), calculations (e.g., determined based on the acquired data and the reference data), etc.

In an example embodiment, such as shown in Figure 1, the simulation component 120 can operate in conjunction with a software framework, such as an object-based framework. In the object-based framework, some or all of the entities can be have pre-defined classes and subclasses that facilitate modeling and simulation. A commercially available example of an object-based framework is the MICROSOFT® .NET® framework (Redmond, Washington), which provides a set of extensible object classes. In the .NET® framework, an object class encapsulates a module of reusable code and associated data structures. Object classes can be used to instantiate object instances for use in a program, script, etc. For example, borehole classes may define objects for representing boreholes based on well data.

In embodiments, such as the example of Figure 1, the simulation component 120 can process information to conform to one or more attributes specified by the attribute component 130, which may include a library of attributes. Such processing may occur prior to input to the simulation component 120 (e.g., consider the computing device 115). As an example, the simulation component 120 may perform operations on input information based on one or more attributes specified by the attribute component 130. In an example embodiment, the simulation component 120 can construct one or more models of the geologic environment 149, which can be relied on to simulate behavior of the geologic environment 149 (e.g., responsive to one or more acts, whether natural or artificial).

In embodiments, such as the example of Figure 1, the analysis/visualization component 142 allows for interaction with a model or model-based results (e.g., simulation results, etc.). For example, the output of the simulation may be presented using an interactive graphical user interface. Further, outputs from the simulation component 120 may be input to one or more other workflows, as indicated by a workflow component 144.

In embodiments, the simulation component 120 can include one or more features of a simulator such as the ECLIPSE™ reservoir simulator (Schlumberger Limited, Houston Texas), the INTERSECT™ reservoir simulator (Schlumberger Limited, Houston Texas), etc. As an example, a simulation component, a simulator, etc. can include features to implement one or more grid-less techniques (e.g., to solve one or more equations, etc.). As an example, a reservoir or reservoirs may be simulated with respect to one or more enhanced recovery techniques (e.g., consider a thermal process such as SAGD, etc.).

In embodiments, the management components 110 can include features of a commercially available framework such as the PETREL® seismic to simulation software framework (Schlumberger Limited, Houston, Texas). The PETREL® framework provides components that allow for optimization of exploration and development operations. The PETREL® framework includes seismic to simulation software components that can output information for use in increasing reservoir performance, for example, by improving asset team productivity. Through use of such a framework, one or more analysts (e.g., geophysicists, geologists, and reservoir engineers) can develop collaborative workflows and integrate operations to streamline processes. Such a framework can be considered an application and can be considered a data-driven application (e.g., where data is input for purposes of modeling, simulating, etc.).

In embodiments, various aspects of the management components 110 may include add-ons or plug-ins that operate according to specifications of a framework environment. For example, a commercially available framework environment marketed as the OCEAN® framework environment (Schlumberger Limited, Houston, Texas) allows for integration of add-ons (or plug-ins) into a PETREL® framework workflow. The OCEAN® framework environment leverages .NET® tools (Microsoft Corporation, Redmond, Washington) and offers stable, user-friendly interfaces for efficient development. In an example embodiment, various components may be implemented as add-ons (or plug-ins) that conform to and operate according to specifications of a framework environment (e.g., according to application programming interface (API) specifications, etc.).

Figure 1 also shows an example of a framework 170 that includes a model simulation layer 180 along with a framework services layer 190, a framework core layer 195 and a modules layer 175. The framework 170 may include the commercially available OCEAN® framework where the model simulation layer 180 is the commercially available PETREL® model-centric software package that hosts OCEAN® framework applications. In an example embodiment, the PETREL® software may be considered a data-driven application. The PETREL® software can include a framework for model building and visualization.

In accordance with aspects of the present disclosure, the framework 170 includes features for implementing one or more grid generation techniques. In embodiments, the framework 170 can include an input component for receipt of information from interpretation of the seismic data, the attributes 130, as well as, for example, log data, image data, etc. Such a framework may include a grid generation component that processes input information, optionally in conjunction with other information, to generate a grid representing three-dimensional divisions of the geologic environment 149. For example, the grid can divide reservoir 151 into a mesh of contiguous rectangular or square cells, which may comprise a finite-difference (FD) or control-volume (CV) based reservoir grids. In accordance with aspects of the disclosure, the geologic modeling and analysis system 100 simulates the reservoir 151 by modeling fluid flow among cells of the grid containing fluid conducting fractures.

In embodiments, such as shown in the example of Figure 1, the model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

As an example, the domain objects 182 can include entity objects, property objects and optionally other objects. Entity objects may be used to geometrically represent wells, surfaces, bodies, reservoirs, fractures, etc., while property objects may be used to provide property values as well as data versions and display parameters. An entity object may represent a fracture in the reservoir where a property object provides log information as well as version information and display information (e.g., to display the well as part of a model).

In the example of Figure 1, the sedimentary basin 150 may have layers (e.g., stratification) that include a reservoir 151 and one or more other features such as the fault 153-1, the geobody 153-2, etc. As an example, the geologic environment 149 may be outfitted with any of a variety of sensors, detectors, actuators, etc. in the sedimentary basin 150. For example, equipment 152 may include communication circuitry to receive and to transmit information with respect to one or more networks 155. Such information may include information associated with downhole equipment 154, which may be equipment to acquire information, to assist with resource recovery, etc. Other equipment 156 may be located remote from a well site and include sensing, detecting, emitting or other circuitry. Such equipment may include storage and communication circuitry to store and to communicate data, instructions, etc. As an example, one or more satellites may be provided for purposes of communications, data acquisition, etc. For example, Figure 1 shows a satellite in communication with the network 155 that may be configured for communications, noting that the satellite may additionally or alternatively includes circuitry for imagery (e.g., spatial, spectral, temporal, radiometric, etc.).

In embodiments, such as shown in Figure 1, the geologic environment 149 can include equipment 157 and 158 associated with a well that includes a substantially horizontal portion that may intersect with the fractures 159. For example, the sedimentary basin 150 can be a shale formation and the fractures 159 can include natural fractures, artificial fractures (e.g., hydraulic fractures) or a combination of natural and artificial fractures in the shale formation. As an example, a well may be drilled for reservoir 151 that is laterally extensive. In such an example, lateral variations in properties, stresses, etc. may exist where an assessment of such variations may assist with planning, operations, etc. to develop a laterally extensive reservoir (e.g., via fracturing, injecting, extracting, etc.). As an example, the equipment 157 and/or 158 may include components, a system, systems, etc. for fracturing, seismic sensing, analysis of seismic data, assessment of the fractures 159, etc.

In accordance with aspects of the present disclosure, the geologic modeling and analysis system 100 can be used to perform one or more workflows, such as workflow 144. Workflow 144 may be a process that includes a number of worksteps. A workstep may operate on data, for example, to create new data, to update existing data, etc. As an example, a workstep may operate on one or more inputs and create one or more results, for example, based on one or more algorithms. As an example, the management components 110 can include a workflow editor for creation, editing, executing, etc. of the workflow 144. In such an example, the workflow editor may provide for selection of one or more pre-defined worksteps, one or more customized worksteps, etc. As an example, the workflow 144 may be a workflow implementable in the PETREL® software, for example, that operates on seismic data, seismic attribute(s), etc. As an example, the workflow 144 may be a process implementable in the OCEAN® framework. As an example, the workflow 144 may include one or more worksteps that access a module such as a plug-in (e.g., external executable code, etc.).

Current methods of modeling fluid-conducting fractures (e.g., fractures 159) include "the dual-porosity/dual-permeability approach" and "the enhanced well index approach." These two approaches are examples of "low-accuracy, low-cost" modeling methods. In both cases, at least some detailed geometry of the fractures in underground geological formations is lost in the macroscopic description of the local system. In addition to the low-accuracy, low-cost modeling methods, current methods include a "medium/high-accuracy, high-cost" method. This method divides an underground geological formation (e.g., sedimentary basin 150) into a grid of cells and then adapts and/or refines the grids cells around a fracture (e.g., fractures 159) by deforming the grid cells (i.e. adapting) and/or shrinking their size (i.e., refining) (i.e., the adapting/refining method).

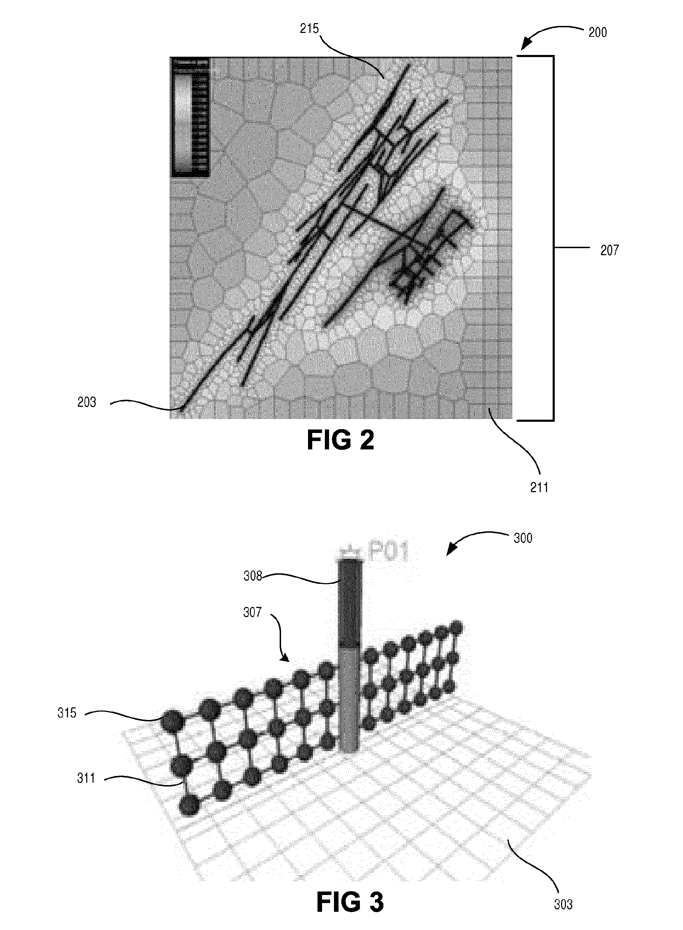

Figure 2 depicts an aerial view of an example of a geological formation 200 including fractures 203. For example, the geologic formation 200 may be rock and the fractures 203 can contain a liquid (e.g., hydrocarbons). A geologic modeling and analysis system (e.g., geologic modeling and analysis system 100) can model the geological formation 200 and fractures 203 by dividing the geological formation 200 into a grid 207 of cells 211. In some embodiments, the cells 211 of the grid 297 may initially be of equal size and/or may be rectangular, but in other embodiments, may be of varying sizes and may take any suitable shape. In accordance with the adapting/refining method, the geologic modeling and analysis system deforms and/or resizes one, some, or all of the cells 211 of the grid 207 based on their proximity to the fractures 203. For example, as depicted in Figure 2, cell 215 has been resized and deformed based on its proximity to the fractures 203 and the shape of the fractures 203, whereas cell 211 has not been resized or deformed. By doing so, the adapting/refining method provides for progressively higher-accuracy and/or higher-resolution modeling in cells in the grid 207 based on their proximity to the fractures 203.

Figure 3 illustrates an example of a multi-segment network model for fluid-conducting fractures. In the multi-segment network model, a geological formation 300 is divided into a three-dimensional grid 303 including a fracture 307 and a wellbore 308. The geological formation 300, fracture 307, and wellbore 308 can be the same or similar to those previously described herein (e.g., sedimentary basin 150, fractures 159, and equipment 157). The interactions between the fracture 307 and cells of the grid 303 are represented by a network of one-dimensional (1D) pipes 311 connected by nodes 315, wherein each of the pipes between any two of the nodes 315 represents a steady-state model of multi-phase fluid-flow following Darcy's law in one dimension. Darcy's law states that the rate at which a fluid flows through a permeable medium (e.g., porous rock) is directly proportional to the pressure difference between two places in the medium and inversely proportional to the distance between them.

In the multi-segment network approach shown in Figure 3, the grid 303 may be unaffected by the presence of the fracture 307, and the fracture 307 may dynamically change its shape and location during implementation of the production strategy. However, because the multi-segment network approach shown in Figure 3 anchors the pipes 311 and nodes 315 to the cells of the grid 303, the pipes 311 and nodes 315 form a rigid network that may not allow for changes in distances between its segments, and that may not be removed. Additionally, when more fractures intersect the same cell of the grid 303, topological information expressing the mutual relationships between individual fractures may be ignored by coupling each fracture with the cell separately and at the cell-scale level. Thus, for example, two fractures far apart within the cell may be modeled in the same way as two fractures crossing each other. Modeling these two situations in the same manner may produce impractical results when, for example, attempting to simulate hydraulic fractures, which are usually created in very tight rocks (e.g., shale). Further, both natural and induced fractures may form a complex system of mutually intersecting fractures that channel fluid along their pressure gradients. The multi-segment network approach may treat each fracture as part of the associated well; however, not every fracture in the real world has an associated well. Regardless, each fracture still plays a role as a cross-connection channel.

In some embodiments, methods and systems disclosed herein may increase the accuracy of the multi-segment network approach shown in Figure 3. The methods and systems perform a process that models fractures (e.g., fractures 159) in a geological formation (e.g. sedimentary basis 150) as 2D layers of fluid within cells of a grid. For each intersection between a particular cell of the grid and a fracture (a.k.a., a fracture cell / reservoir cell intersection, "FCRCI"), the process uses analytically accurate boundary integral equations (i.e., "BIEs") to model the fracture. The 2D model of fluid flow inside the fracture allows adjusting the fracture cell sizes independently of the reservoir cell sizes. Thus, a model of the fracture can be coarsened or refined based on, e.g., conductivity of the fractures. For example, highly-conductive fractures may exhibit small pressure gradients and, hence, larger fracture cell sizes can be used to reduce the number of unknowns in the model with little or no loss of accuracy.

Moreover, embodiments of the present disclosure determine the flow through the FCRCI analytically. For example, a simulation (e.g., simulation 120) can use fluid flow parameters corresponding to the geometry of the reservoir cells and the fracture cells intersecting the reservoir cell, as well as the current distribution of pressures around the reservoir cell, representing nearby rock heterogeneities and the influence of external wells and aquifers. In embodiments, when it is determined that transient effects of the FCRCI flow are relevant (e.g., by a user), a default steady-state model in the simulation can be replaced by a transient model by involving time-dependent kernels in the boundary integral equations.

In addition, in accordance with aspects of the present disclosure, a fracture may be treated as a reservoir domain model. This is due to the fact that a fluid-conducting fracture is effectively a porous rock layer with (very) high porosity and permeability. Thus, in embodiments, simulation facilities that can be applied to domain grids may be applied to the fracture model. For example, computations and properties related to rock compaction, not applicable to the well model, may be provided. Further, a reservoir fluid-flow simulator may be coupled with a rock-stress/strain simulator, resulting in dynamic fracture growths or closures based on fluid pressure changes during the production.

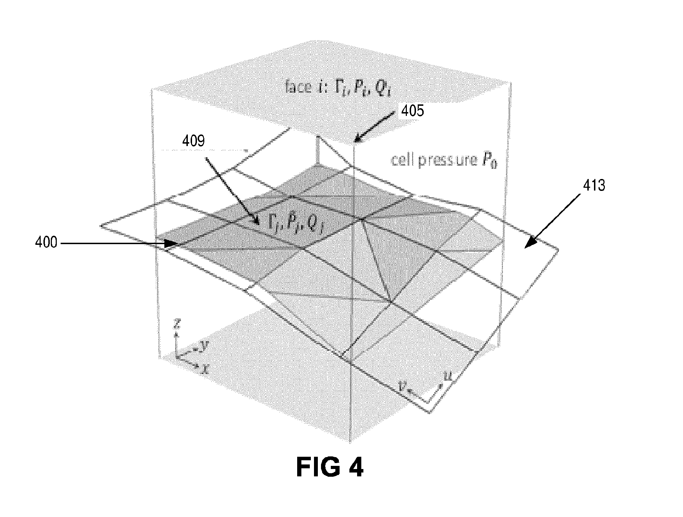

Figure 4 illustrates a model of a FCRCI 400 including a reservoir cell 405 and a number of fracture cells 409 of a fracture 413 in accordance with aspects of the present disclosure. The fracture 413 can be the same or similar to the fractures (e.g., fractures 159) previously discussed herein. In accordance with aspects of the present disclosure, the fracture 413 may be planar or non-planar conductive liquid channel that intersects the reservoir cell 405. In embodiments, such as the example shown in Figure 4, the reservoir cell 405 is a cell in a 3D domain (e.g., x, y, z) of a reservoir (e.g., reservoir 151) that has been split into a grid (e.g., mesh) of contiguous volumetric cells. For the sake of illustration, the reservoir cell 405 is depicted in Figure 4 as a rectangular prism that, in combination with other reservoir cells, (not shown) forms the reservoir grid model. However, it is understood that the reservoir cell 405 is not limited to rectangular shapes and that embodiments of the present disclosure can be implemented using non-rectangular cells.

In accordance with aspects of the invention, the portion of the fracture 413 intersecting the reservoir cell 405 is represented by splitting the fracture 413 into the fracture cells 409. The fracture cells 409 are planar cells in a 2D domain (e.g., u, v) of the fracture 413 that represent a curvature and/or shape of the portion of the fracture 413 intersecting the reservoir cell 405. In Figure 4, the fracture cells 409 are depicted as shaded triangles and quadrilaterals. In some embodiments, a user may determine a degree of curvature-discretization into planar cells. Notably, even though the fracture cells 409 are modeled as planar cells, the simulation can associate thicknesses with some or all of the fracture cells 409 based on, e.g., fluid conduction information. The fracture thickness may be obtained from measurements in the field and subsequent geologic modeling techniques. In accordance with aspects of the present disclosure, the fracture dimensions (e.g., area and width) may vary among the fracture cells 409 and, together with the fracture permeability, define the internal fluid transmissivity of each fracture cell 409. Further, as noted above, sizes of the fracture cells 409 can be selectively varied (e.g., by an analyst) to reduce the number of unknowns in a model and, thereby, reduce computational cost and/or complexity.

Additionally, in embodiments, the simulation can assign a unique pressure to each of the fracture cells 409. It is noted that Figure 4 shows pressure $\tilde{P}_j$ for a particular fracture cell 409, which is in domain $\Gamma_j$, nevertheless the same pressure may be shared by some or all fracture cells 409 in the model of the FCRCI 400, depending on needs of an analyst to represent expected gradients within the fracture 413 and the opposing need to reduce overall computational costs (and hence the number of unknowns). For example, as the pressure $P_0$ can be uniform throughout the reservoir cell 405, an analyst may represent the pressure $\tilde{P}_j$ of the fracture 413 for the entire model of the FCRCI 400 in terms of a single variable, to simplify the model of the FCRCI 400 by using a smaller number of unknowns. However, if the curvature of the fracture 413 is more profound or if the internal fluid transmissivity of the fracture 413 is lower, pressure gradients inside each FCRCI 400 of the model might be significant, and therefore each fracture cell 409 might be assigned its own pressure $\tilde{P}_j$. Doing so would increase the modeling accuracy but also the computational demands.

In accordance with aspects of the present disclosure, equations (1), (2), (3), and (4) below mathematically describe the model of the FCRCI 400: reservoir cell 405:

$$\sum_{i=1}^{n} Q_i + \sum_{rwc} Q_{rwc} + \sum_{j=1}^{f} Q_j + \frac{1}{\rho}\frac{\Delta(\rho\phi V)}{\Delta t} = 0 , \quad \text{in } (x, y, z) \qquad (1)$$

$$Q_i = -T_i M_i (P_i - P_0) + S_i \qquad (2)$$

fracture cell 409:

$$\sum_{k=1}^{m} \tilde{Q}_k + \sum_{fwc} \tilde{Q}_{fwc} - \sum_{j=1}^{r} Q_j + \frac{1}{\rho}\frac{\Delta(\rho\tilde{\phi}\tilde{V})}{\Delta t'} = 0 , \quad \text{in } (u, v) \qquad (3)$$

$$\tilde{Q}_k = -\tilde{T}_k M_k (\tilde{P}_k - \tilde{P}_0) \qquad (4)$$

Equation (1) represents a material balance of fluid flowing from reservoir cell 405 (i) into its n neighboring (e.g., adjacent) reservoir cells (first parameter) in the reservoir grid, (ii) into well connections rwc outside (i.e., excluding) the fracture cells 409 (second parameter), (iii) into f fracture cells 409 (third parameter) intersecting the reservoir cell 405, and (iv) and of fluid compressed during the time step $\Delta t$ due to changes in (molar or mass) fluid density $\rho$ or pore volume $\phi V$ (fourth parameter). Flow-rate $Q_i$ across the face $\Gamma_i$ from reservoir cell 405 into cell i depends, according to Darcy's law, on the pressure difference between the two cells (including hydrostatic effects), $P_i - P_0$, multiplied by transmissibility $T_i$ and mobility $M_i$, see Equation (2). At this stage, the extra parameter $S_i$ may be ignored (i.e., set to zero).

The flow of fluid through fractures 413 of the FCRCI 400 has an analogous control-volume (i.e., CV) description, except that its 2D domain is defined by the surface of the fracture 413, which can be curved in 3D space (e.g., x, y, z), and can, therefore, be based on the curvilinear coordinates (u, v) that map the original non-planar domain onto a flat plane. This difference is also indicated by a tilde-accent above symbols of the relevant quantities in Equations (3) and (4).

In the first parameter of Equation (3), m is number of fracture cells 409 neighboring (e.g., adjacent) to fracture cell 409. For example, if the fracture grid is made up of triangular cells 409, m may be 3, whereas n may equal 6 in a 3D grid of cuboidal cells 405. Index fwc in the second parameter iterates over the well connections explicitly associated with the fracture cell 409, and therefore excluded from the rwc-sum in Equation (1). In Equation (3), time step $\Delta t'$ may be different (usually smaller) from $\Delta t$ in Equation (1) to cope with the higher velocities of fluid in the fracture system.

As is evident from a comparison of Equations (1) and (3), their third parameter couples the two models. In Equation (3), r is the number of reservoir cells intersecting each of the fracture cells 409 and each of them is supplying $Q_j$ of fluid to it across both sides of the planar boundary $\Gamma_j$, unless the fracture cell 409 lies exactly between two reservoir cells.

In accordance with aspects of the present disclosure, simulation (e.g., simulation 120) determines the unknown value of each $Q_j$ based on the local geometry, rock and fluid properties, and pressures. In embodiments, the simulation uses a boundary integral equation to determine the values of each $Q_j$. The boundary integral equation considers boundaries and can optionally determine domain solutions. The domain in this setup may be the reservoir cell 405 in which the properties may be considered to be spatially uniform, as dictated by the finite-difference or control-volume method used to discretize the space. Doing so can simplify aspects of the boundary integral equation method. It should be noted that the boundary integral equation (a.k.a., boundary element method (BEM)) which can prescribe a variable solution distribution along the domain boundaries is based on simple functions such as low-order polynomials. In the current context, pressures and flow-rates are constant over all finite-difference or control-volume cell faces, which correspond to constant boundary elements.

In embodiments, the simulation represents the fracture in 3D using both-sided boundary elements to halve the number of unknowns or to apply finite element method (FEM) for a more accurate 2D fracture description. These may be adapted to the FD/CV based reservoir (3D) and fracture (2D) description in which the interior of each reservoir cell containing fractures is modeled using the BIE approach to facilitate the rock-fracture coupling.

Equation (5) below is the fundamental equation of the BIE method that represents the influence of a point source in x' onto the boundaries of the solution domain. In accordance with aspects of the disclosure, the solution domain is the reservoir cell 405:

$$c(\mathbf{x'})\,P(\mathbf{x'}) = \sum_{i=1}^{n} P_i \int_{\Gamma_i} F(\mathbf{x}-\mathbf{x'})d\gamma \;-\; \sum_{i=1}^{n} \frac{Q_i}{|\Gamma_i|} \int_{\Gamma_i} G(\mathbf{x}-\mathbf{x'})d\gamma \;-$$

$$\sum_{rwc} \frac{Q_{rwc}}{|\Gamma_{rwc}|} \int_{\Gamma_{rwc}} G(\mathbf{x}-\mathbf{x'})d\gamma \;-\; \sum_{j=1}^{f} \frac{2Q_j}{|\Gamma_j|} \int_{\Gamma_j} G(\mathbf{x}-\mathbf{x'})d\gamma + I_{\mathrm{acc}} \tag{5}$$

Kernels F and G capture the geometry between points x' and x as the latter moves along each boundary $\Gamma_*$ during the integration. Steady-state kernel G corresponds to a reciprocal of the distance between the two points and F to its spatial gradient. Further, time-dependent kernels can be used to localize fluid expansion or compression, in addition to the cell-wise-uniform accumulation included via parameter $I_{\mathrm{acc}}$. Parameter $|\Gamma_*|$ in Equation (5) denotes the area of boundary $\Gamma_*$.

The parameters in Equation (5) are known at the solution time t (some are estimated at time t+Δt), except for the flow-rate $Q_j$ across each fracture cell side-face $\Gamma_j$. Equation (5) can be used to determine this unknown flow-rate, which couples the two models, by positioning point x' on boundary $\Gamma_j$, setting contact coefficient c(x') to 0.5 (~ smooth boundary) and taking P(x') equal to the fracture pressure $\tilde{P}_j$ at x'. This procedure could be repeated for all f fracture cells 409 in the reservoir cell 405 to generate f equations for the same number of unknowns $Q_j$. Further, the sides of the fracture boundary $\Gamma_j$ may be treated independently, instead of using the both-sided boundary element approach; however, this would double the number of unknowns $Q_j$.

The methods of the present disclosure provide a high-accuracy model of flow between conductive fractures and rock cells in FD or CV-based reservoir grids. Notably, modeling internal sources or sinks within such FD or CV-based reservoir grids involves changes in cell pressure that can cause a symmetrically distributed gradient around the cell in all directions. Additionally, the model may include additional unknowns, $S_i$ in Equation (2), called the "support flow." The inclusion of support flow $S_i$ in the model can improve the determined flow-rates $Q_i$ by compensating the error arising from the crude FD/CV-based description with the help of boundary integral equations with x'on $\Gamma_i$. When the support flow is included in Equation (2), the pressure gradient around the cell 405 may be asymmetric, depending on the geometry and distribution of the internal sources and fractures cells. Doing so can yield a more accurate solution because it provides more degrees of freedom.

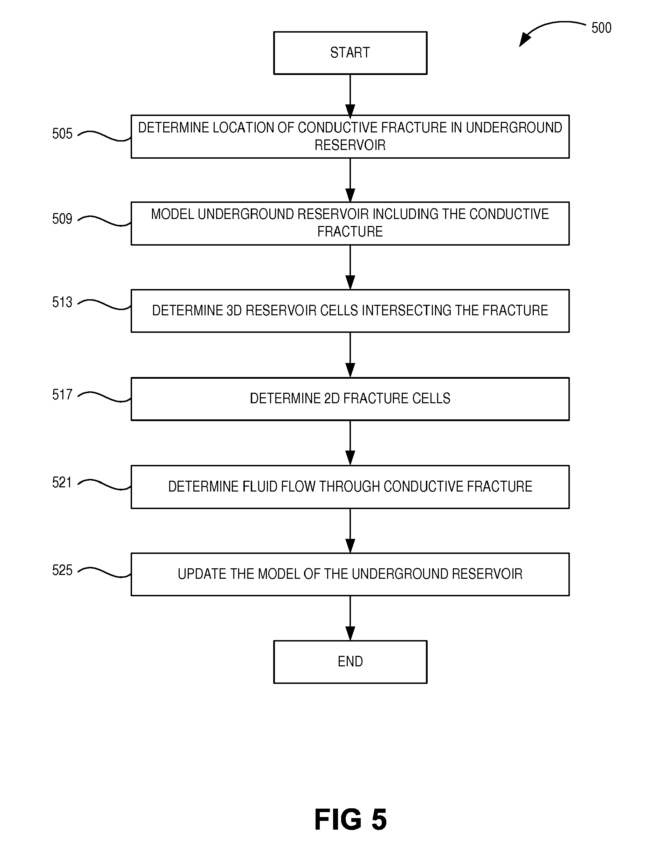

The flowchart in Figure 5 illustrates functionality and operation of possible implementations of systems, devices, methods, and computer program products according to various embodiments of the present disclosure. Each block in the flow diagram of Figure 5 can represent a module, segment, or portion of program instructions, which includes one or more computer executable instructions for implementing the illustrated functions and operations. In some implementations, the functions and/or operations illustrated in a particular block of the flow diagram can occur out of the order shown in Figure 5. For example, two blocks shown in succession can be executed substantially concurrently, or the blocks can sometimes be executed in the reverse order, depending upon the functionality involved. It will also be noted that each block of the flow diagram and combinations of blocks in the block can be implemented by special purpose hardware-based systems that perform the specified functions or acts, or combinations of special purpose hardware and computer instructions.

Figure 5 illustrates a flow diagram of an example of a process 500 for modeling fluid-conducting fractures in a reservoir grid. The process 500 can be implemented using the environment of Figure 1. At 505, a system (e.g., geologic modeling and analysis system 100) determines locations of conductive fractures (e.g., fracture 413) in an underground reservoir (e.g., a sedimentary basin 150). For example, the system can use sensing, drilling, injecting, etc. to determine information (e.g., seismic data 112 and other information 114) about the underground reservoir. The information can include estimated locations of conductive fractures.

At 509, the system (e.g., using simulation 120) determines a model of the underground reservoir based on the information determined at 505. In accordance with aspects of the disclosure, the model can be a 3D grid comprised of volumetric reservoir cells (e.g., reservoir cell 405). At 513, the system determines which of the reservoir cells determined at 509 intersect the locations of the conductive fracture determined in 505. For example, at each of the reservoir cells, the system estimates a location, a shape, and/or a thickness of the fracture within the 3D domain of the 3D grid.

At 517, the system determines 2D fracture cells (e.g., fracture cells 409) representing the conductive fracture in the model. In embodiments, the fracture cells are determined by splitting a portion of the conductive fracture intersecting each reservoir cell into a number of 2D polygons representing a curved shape of the portion of the conductive fracture. It is noted that, while the fracture cells can be two-dimensional, they can be associated with a volume of fluid based on, e.g., fluid density and pore volume of the portion of the conductive fracture. An analyst may select the size and/or shape of the fracture cells to reduce the number of unknowns in the model.

At 521, the system determines fluid flow through the conductive fracture using one or more fluid flow parameters of each of the reservoir cells determined in 513 and fluid flow parameters of each of the fracture cells determined at 517. The fluid flow parameters can correspond to those previously disclosed herein. In embodiments, the fluid flow parameters are variables included in one or more of Equations (1) ... (5) above. At 525, the system updates the model based on the fluid flow condition determined at 521. For example, the system can update the model based on the fluid flow between the reservoir cells and the fracture cells. Steps 521 and 525 may be performed simultaneously by solving a single matrix representing Equations (1) ... (5) together (including the FD/CV-based residual equations).

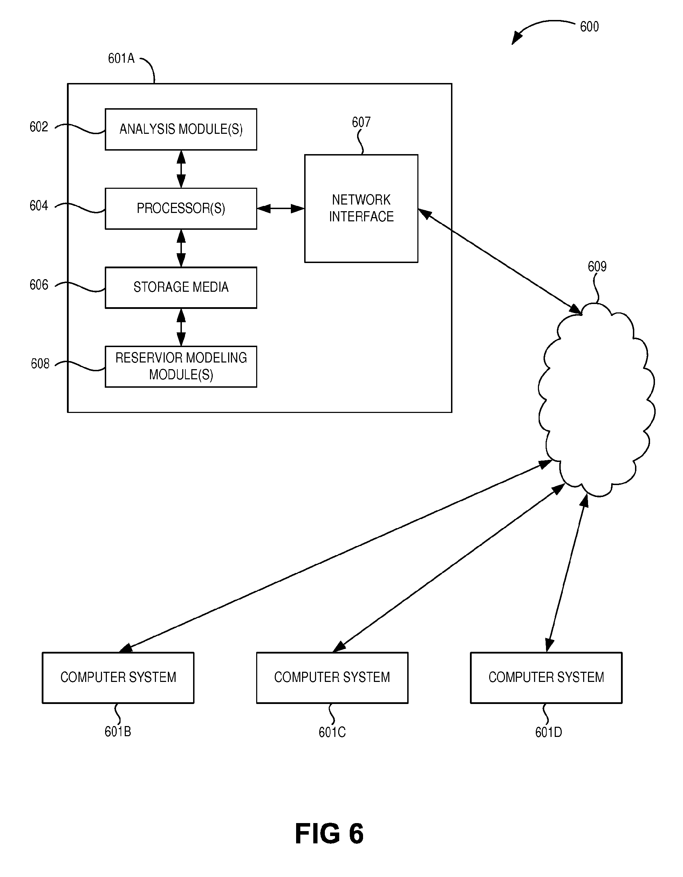

Figure 6 illustrates a block diagram of a computing system 600 in accordance with aspects of the present disclosure. In some embodiments, the methods of the present disclosure may be executed by a computing system 600, which may be the same or similar to the system previously described herein (e.g., geologic modeling and analysis system 100). Figure 6 illustrates an example of such a computing system 600, in accordance with some embodiments. The computing system 600 may include a computer or computer system 601 A, which may be an individual computer system 601A or an arrangement of distributed computer systems. The computer system 601A can be the same or similar to that previously described herein (e.g., computing device 115). The computer system 601A includes one or more analysis modules 602 (modules 175, model simulation 180, etc.) that are configured to perform various tasks according to some embodiments, such as one or more methods disclosed herein (e.g., process 500). To perform these various tasks, the analysis module 602 executes independently, or in coordination with, one or more processors 604, which is (or are) connected to one or more storage media 606. The processor(s) 604 is (or are) also connected to a network interface 607 to allow the computer system 601A to communicate over a data network 609 with one or more additional computer systems and/or computing systems, such as 601B, 601C, and/or 601D (note that computer systems 601B, 601C and/or 601D may or may not share the same architecture as computer system 601A, and may be located in different physical locations, e.g., computer systems 601A and 601B may be located in a processing facility, while in communication with one or more computer systems such as 601C and/or 601D that are located in one or more data centers, and/or located in varying countries on different continents).

A processor may include a microprocessor, microcontroller, processor module or subsystem, programmable integrated circuit, programmable gate array, or another control or computing device. The storage media 606 may be implemented as one or more computer-readable or machine-readable storage media. Note that while in the example embodiment of Figure 6 storage media 606 is depicted as within computer system 601A, in some embodiments, storage media 606 may be distributed within and/or across multiple internal and/or external enclosures of computing system 601A and/or additional computing systems. Storage media 606 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLUERAY® disks, or other types of optical storage, or other types of storage devices. Note that the instructions discussed above may be provided on one computer-readable or machine-readable storage medium, or alternatively, may be provided on multiple computer-readable or machine-readable storage media distributed in a large system having possibly plural nodes. Such computer-readable or machine-readable storage medium or media is (are) considered to be part of an article (or article of manufacture). An article or article of manufacture may refer to any manufactured single component or multiple components. The storage medium or media may be located either in the machine running the machine-readable instructions, or located at a remote site from which machine-readable instructions may be downloaded over a network for execution.

In some embodiments, computing system 600 contains one or more reservoir modeling modules 608. In the example of computing system 600, computer system 601A includes the reservoir modeling modules 608. In some embodiments, a single reservoir modeling module 608 may be used to perform some or all aspects of one or more embodiments of the methods disclosed herein. In alternate embodiments, a plurality of reservoir modeling modules 608 may be used to perform some or all aspects of methods herein.

It should be appreciated that computing system 600 is one example of a computing system, and that computing system 600 may have more or fewer components than shown, may combine additional components not depicted in the example embodiment of Figure 6, and/or computing system 600 may have a different configuration or arrangement of the components depicted in Figure 6. The various components shown in Figure 6 may be implemented in hardware, software, or a combination of both hardware and software, including one or more signal processing and/or application specific integrated circuits.

Further, the processing method described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are included within the scope of protection of the present disclosure.

Geologic interpretations, models, and/or other interpretation aids may be refined in an iterative fashion; this concept is applicable to the methods discussed herein. This may include use of feedback loops executed on an algorithmic basis, such as at a computing device (e.g., computing system 100, Figure 6), and/or through manual control by a user who may make determinations regarding whether a given step, action, template, model, or set of curves has become sufficiently accurate for the evaluation of the subsurface three-dimensional geologic formation under consideration.

The flow diagram in Figure 6 illustrates functionality and operation of possible implementations of systems, devices, methods, and computer program products according to various embodiments of the present disclosure. Each block in the flow diagrams of Figure 6 can represent a module, segment, or portion of program instructions, which includes one or more computer executable instructions for implementing the illustrated functions and operations. In some alternative implementations, the functions and/or operations illustrated in a particular block of the flow diagrams can occur out of the order shown in Figure 6. For example, two blocks shown in succession can be executed substantially concurrently, or the blocks can sometimes be executed in the reverse order, depending upon the functionality involved. It will also be noted that each block of the flow diagrams and combinations of blocks in the block can be implemented by special purpose hardware-based systems that perform the specified functions or acts, or combinations of special purpose hardware and computer instructions.

The foregoing description, for purpose of explanation, has been described with reference to specific embodiments. However, the illustrative discussions above are not intended to be exhaustive or to limit the present disclosure to the precise forms disclosed. Many modifications and variations are possible in view of the above teachings. Moreover, the order in which the elements of the methods described herein are illustrated and described may be rearranged, and/or two or more elements may occur simultaneously. The embodiments were chosen and described in order to best explain the principals of the present disclosure and its practical applications, to thereby enable others skilled in the art to best utilize the present disclosure and various embodiments with various modifications as are suited to the particular use contemplated. Additional information supporting the disclosure is contained in the appendix attached hereto.

It will also be understood that, although the terms first, second, etc. may be used herein to describe various elements, these elements should not be limited by these terms. These terms are used to distinguish one element from another. For example, a first object or step could be termed a second object or step, and, similarly, a second object or step could be termed a first object or step, without departing from the scope of the present disclosure. The first object or step, and the second object or step, are both, objects or steps, respectively, but they are not to be considered the same object or step.

The terminology used in the present disclosure is for the purpose of describing particular embodiments and is not intended to be limiting of the present disclosure. As used in the present disclosure and the appended claims, the singular forms "a," "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises" and/or "comprising," when used in this specification, specify the presence of stated features, integers, steps, operations, elements, and/or components, but do not preclude the presence or addition of one or more other features, integers, steps, operations, elements, components, and/or groups thereof Further, as used herein, the term "if" may be construed to mean "when" or "upon" or "in response to determining" or "in response to detecting," depending on the context.

**Claims**

1. A method comprising:

    determining a model of an underground reservoir, the model comprising a conductive fracture and a grid of three-dimensional (3D) reservoir cells;
    determining a plurality of the 3D reservoir cells intersecting the conductive fracture;
    determining a plurality of two-dimensional (2D) fracture cells representing the conductive fracture in the model;
    determining fluid flow through the conductive fracture using fluid flow parameters of the plurality of the 3D reservoir cells and fluid flow parameters of the plurality of 2D fracture cells; and
    updating the model based on the fluid flow.

2. The method of claim 1, wherein the plurality of 2D fracture cells represent a curvature of the conductive fracture.

3. The method of claim 1, wherein the determining the fluid flow includes assigning thicknesses of the fracture to the plurality of 2D fracture cells.

4. The method of claim 1, wherein the fluid flow parameters of the plurality of the 3D reservoir cells correspond to geometries of the plurality of 3D reservoir cells and the fluid flow parameters of the plurality of the 2D fracture cells correspond to geometries of the plurality of 2D fracture cells.

5. The method of claim 4, wherein the fluid flow parameters of the plurality of the 3D reservoir cells correspond to a current distribution of pressures around each of the plurality of 3D reservoir cells.

6. The method of claim 1, wherein:

the fluid flow parameters of the plurality of the 3D reservoir cells model the plurality of 3D reservoir cells in a 3D domain corresponding to the underground reservoir; and
the fluid flow parameters of the plurality of the 2D fracture cells model the plurality of 2D fracture cells in a 2D domain corresponding to a surface of the fracture.

7. The method of claim 6, wherein the fluid flow parameters of the plurality of the 3D reservoir cells model individual 3D reservoir cells of the plurality of 3D reservoir cells based on:

a balance of fluid flowing from or into neighboring 3D reservoir cells of the individual 3D reservoir cells;
a balance of fluid flowing into well connections outside the individual 3D reservoir cells;
a balance of fluid flowing into the plurality of 2D fracture cells intersecting the individual 3D reservoir cells; and
a balance of fluid compressed due to changes in fluid density or pore volume.

8. The method of claim 6, wherein the fluid flow parameters of the plurality of the 2D fracture cells model individual 2D fracture cells of the plurality of 2D fractures cells based on:

a balance of fluid flowing from or into neighboring 2D fracture cells of the individual 2D fracture cells;
a balance of fluid flowing into well connections associated with the individual 2D fracture cells;
a balance of fluid flowing into the individual 3D reservoir cells intersecting the individual 2D fracture cells; and
a balance of fluid compressed due to changes in fluid density or pore volume.

9. The method of claim 1, wherein the determining fluid flow comprises, for each 3D reservoir cell of the plurality of 3D reservoir cells, determining a flow rate across sides of the plurality of 2D fracture cells intersecting each 3D reservoir cell.

10. The method of claim 1, wherein the updating the model comprises adjusting sizes of one or more of the plurality of the 2D fracture cells independently of sizes of the 3D reservoir cells.

11. A computing system, comprising:

one or more processors; and
a memory system comprising one or more non-transitory computer-readable media storing instructions that, when executed by at least one of the one or more processors, cause the computing system to perform operations, the operations comprising:

determining a model of an underground reservoir, the model comprising of a conductive fracture and a grid of three-dimensional (3D) reservoir cells;
determining a plurality of the 3D reservoir cells intersecting the conductive fracture;
determining a plurality of two-dimensional (2D) fracture cells representing the conductive fracture in the model;
determining fluid flow through the conductive fracture using fluid flow parameters of the plurality of the 3D reservoir cells and fluid flow parameters of the plurality of 2D fracture cells; and
updating the model based on the fluid flow.

12. The system of claim 11, wherein the plurality of 2D fracture cells represent a curvature of the conductive fracture.

13. The system of claim 11, wherein the fluid flow parameters of the plurality of the 3D reservoir cells correspond to geometries of the plurality of 3D reservoir cells and the fluid flow parameters of the plurality of the 2D fracture cells correspond to geometries of the plurality of 2D fracture cells.

14. The system of claim 13, wherein the fluid flow parameters of the plurality of the 3D reservoir cells correspond to a current distribution of pressures around each of the plurality of 3D reservoir cells.

15. The system of claim 11, wherein:

the fluid flow parameters of the plurality of the 3D reservoir cells model the plurality of 3D reservoir cells in a 3D domain corresponding to the underground reservoir; and
the fluid flow parameters of the plurality of the 2D fracture cells model the plurality of 2D fracture cells in a 2D domain corresponding to a surface of the fracture.

16. The system of claim 15, wherein the fluid flow parameters of the plurality of the 3D reservoir cells model individual 3D reservoir cells of the plurality of 3D reservoir cells based on:

a balance of fluid flowing from or into neighboring 3D reservoir cells of the individual 3D reservoir cells;
a balance of fluid flowing into well connections outside the individual 3D reservoir cells;
a balance of fluid flowing into the plurality of 2D fracture cells intersecting the individual 3D reservoir cells; and
a balance of fluid compressed due to changes in fluid density or pore volume.

17. The system of claim 15, wherein the fluid flow parameters of the plurality of the 2D fracture cells model individual 2D fracture cells of the plurality of 2D fractures cells based on:

a balance of fluid flowing from or into neighboring 2D fracture cells of the individual 2D fracture cells;
a balance of fluid flowing into well connections associated with the individual 2D fracture cells;
a balance of fluid flowing into the individual 3D reservoir cells intersecting the individual 2D fracture cells; and
a balance of fluid compressed due to changes in fluid density or pore volume.

18. The system of claim 11, wherein the determining fluid flow comprises, for each 3D reservoir cell of the plurality of 3D reservoir cells, determining a flow rate across sides of the plurality of 2D fracture cells intersecting each 3D reservoir cell.

19. The system of claim 11, wherein the updating the model comprises adjusting sizes of one or more of the plurality of 2D fracture cells independently of sizes of the 3D reservoir cells.

20. A computer program product comprising non-transitory computer-readable device storing program instructions that, when executed by at least one processor of a computing system, cause the computing system to perform operations, the operations comprising:

determining a model of an underground reservoir, the model comprising a conductive fracture and a grid of three-dimensional (3D) reservoir cells;
determining a plurality of the 3D reservoir cells intersecting the conductive fracture;
determining a plurality of two-dimensional (2D) fracture cells representing the conductive fracture in the model;
determining fluid flow through the conductive fracture using fluid flow parameters of the plurality of the 3D reservoir cells and fluid flow parameters of the plurality of 2D fracture cells; and
updating the model based on the fluid flow.

10

GEOLOGIC MODELLING AND ANALYSIS SYSTEM 100

MANAGEMENT COMPONENTS 110

FRAMEWORK 170

| SEISMIC DATA 112 | ADDITIONAL INFORMATION 114 |
|---|---|

| DATA STORAGE DEVICE 116 | COMPUTING DEVICE 115 |
|---|---|

| ENTITIES 122 | SIMULATION 120 | ATTRIBUTE 130 |
|---|---|---|

| ANALYSIS/ VISUALIZATION 142 | WORKFLOW 144 |
|---|---|

MODULES 175

MODEL SIMULATION 180

FRAMEWORK SERVICES 190

FRAMEWORK CORE 195

DOMAIN OBJECTS 182

DATA SOURCE 184

RENDERING 186

USER INTERFACES 188

160

GEOLOGIC ENVIRONMENT 149
(E.G., SENSING, DRILLING, INJECTING, EXTRACTING, ETC.)

1000

0

1000

2000

3000

4000

5000

157

158

159

155

152

156

153-1

154

151

150

153-2

**FIG. 1**

**FIG 2**

**FIG 3**

FIG 4

500

START

505 — DETERMINE LOCATION OF CONDUCTIVE FRACTURE IN UNDERGROUND RESERVOIR

509 — MODEL UNDERGROUND RESERVOIR INCLUDING THE CONDUCTIVE FRACTURE

513 — DETERMINE 3D RESERVOIR CELLS INTERSECTING THE FRACTURE

517 — DETERMINE 2D FRACTURE CELLS

521 — DETERMINE FLUID FLOW THROUGH CONDUCTIVE FRACTURE

525 — UPDATE THE MODEL OF THE UNDERGROUND RESERVOIR

END

# FIG 5

**FIG 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62076943 A